Europäisches Patentamt

European Patent Office

Office européen des brevets

(11) Publication number: **0 321 794**
**A2**

## (12) EUROPEAN PATENT APPLICATION

(21) Application number: 88120536.3

(22) Date of filing: 08.12.88

(51) Int. Cl.⁴: **H03K 4/02 , H03K 4/06**

(30) Priority: 23.12.87 IT 2318087

(43) Date of publication of application:
28.06.89 Bulletin 89/26

(84) Designated Contracting States:
DE FR GB NL SE

(71) Applicant: SGS-THOMSON
MICROELECTRONICS s.r.l.
Via C. Olivetti, 2
I-20041 Agrate Brianza Milan(IT)

(72) Inventor: Marchio', Fabio
Via Giusti, 10
I-21013 Gallarate (Varese)(IT)
Inventor: Morelli, Marco
Via Temistocle Guerrazzi, 71
I-57100 Livorno(IT)
Inventor: Tricoli, Francesco
Via Taggia, 30
I-20153 Milano(IT)

(74) Representative: Mittler, Enrico et al
c/o Marchi & Mittler s.r.l. Viale Lombardia, 20
I-20131 Milano(IT)

(54) Low frequency triangular wave generator easy to integrate.

(57) A high frequency pulse generator (11) pilots an up and down pulse counter (12) equipped with a counting direction reversing circuit (13). A digital/analog converter (16) converts the succession of counting states of the counter (12) into an approximately triangular low frequency stepped wave.

Fig.1

## Low frequency triangular wave generator easy to integrate

The present invention relates to a low frequency triangular wave generator easy to integrate.

There are many electronic systems which call for the use of a triangular wave generator. This is true in particular for PWM (Pulse Width Modulation) regulation, for which is necessary a triangular wave generator with frequency equal to switching frequency.

In the most common cases the frequency required for the triangular wave generator is between 10kHz and 1MHz, which are values easily achieved by a generator equipped with a relatively small capacitance condenser which thus lends itself to inclusion in an integrated circuit.

But there are applications, e.g. voltage regulators for automobile alternators, in which the triangular wave generator operating frequency must be much lower, practically between 100Hz and 500Hz.

Since the frequency of a triangular wave generator varies in inverse ratio to the capacitance of its condenser and in direct ratio to the charge current of said condenser, to secure a very low frequency it would be necessary to increase capacitance or reduce charging current. An excessively large capacitance condenser however cannot be inserted in an integrated circuit, if only because of the considerable waste of silicon this would entail, and as regards current it must be remembered that in an integrated circuit there is a relatively high current loss (if compared with the small charging current necessary to secure the low frequency), which makes it impossible to improve the capacity to current ratio.

In short, considering present knowledge, a low frequency triangular wave generator does not lend itself to integration.

The object of the present invention is to accomplish a low frequency triangular wave generator which would be easy to integrate. In accordance with the invention said object is achieved by a generator characterized in that it comprises a high frequency pulse generator, an up and down pulse counter with $n$ output bits equipped with a circuit to reverse the counting direction, and a digital/analog converter placed at the output of said counter.

In this manner from a high frequency pulse generator having a condenser with small capacitance and hence easy to integrate, as is the up and down counter, the reversing circuit (basically a flip-flop) and the digital/analog converter, it is possible to secure, for counting and subsequent integration, an approximately triangular stepped wave having a frequency much lower than the starting frequency.

In other words the desired low frequency triangular wave using components all easily assembled in an integrated circuit is obtained.

The features of the present invention will be better understood by referring to the annexed drawings wherein..

FIG. 1 shows the basic diagram of the triangular wave generator in accordance with the present invention,

FIG. 2 shows the approximately triangular low frequency stepped wave form obtainable at the output of the generator of FIG. 1, and

FIG. 3 shows a possible embodiment of the high frequency pulse generator included in the diagram of FIG. 1.

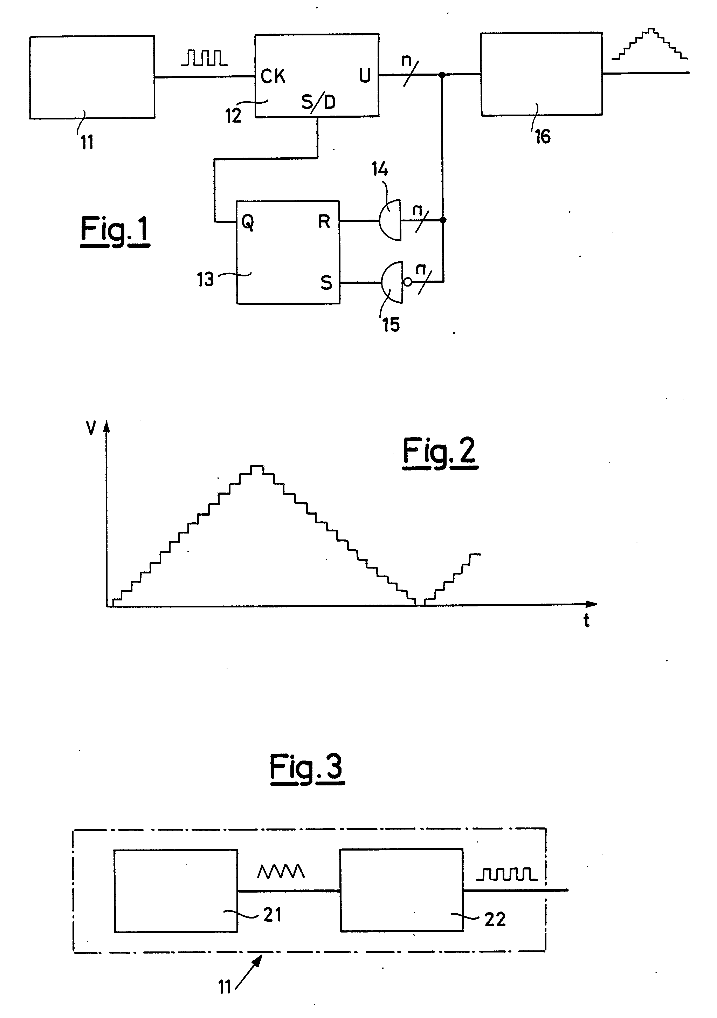

The low frequency triangular wave generator illustrated in FIG. 1 comprises a high frequency pulse generator 11 which supplies the input CK of an up and down pulse counter 12 provided with a number $n$ of binary outputs U, i.e. n output bits, and a reversing input S/D. This last is controlled by the output Q of a flip-flop reversing circuit 13 with inputs R (reset) and S (set) connected to the outputs of respective AND ports 14 and 15. The port 14 receives the $n$ outputs U of the counter 12 while the port 15 receives the same outputs reversed. The n outputs U of the counter 12 are also received by a digital/analog converter 16 which converts the succession of counting states of the counter 12 into a voltage with approximately triangular stepped wave form as shown in FIG. 2 where V indicates voltage and $t$ time.

The triangular wave generator of FIG. 1 operates as follows. The pulse generator 11 delivers high frequency pulses (e.g. 12.8kHz) at the input CK of the counter 12, which counts them, thus bringing about successive combinations of bits at the output U, for example starting from all "0" bits until all "1" bits are obtained. At this point the AND port 14 resets the flip-flop 13, whose output Q commands the counter 12 to reverse counting direction to down from up. When all the outputs of the counter 12 are then returned to "0" the AND port 15 sets the flip-flop 13, whose output Q commands another counting reversal of the counter 12, from down to up. The digital/analog converter 16 converts the described succession of bit combinations on the output of the counter 12 into a succession of voltage steps which, adding to and subtracting from each other due to the known integration effects of converters of this type, originate the voltage with approximately triangular wave form which is shown in FIG. 2.

Since the possible bit combinations at the outputs of the counter 12 are equal to $2^n$, where $n$ is

the number of outputs, and the counter performing an up counting cycle and then a down counting cycle, thus equal to 2 cycles of the above combinations, the frequency of the triangular wave generated is reduced by a factor of $2^n$. $2 = 2^{n+1}$ compared to that of the pulses of the generator 1.

This means that from a high frequency pulse generator (thus with a perfectly integrable small capacity condenser) there is obtained through other simple circuit components which are known and also perfectly integrable a low frequency triangular wave as desired.

The frequency ratio is brought about by the number n of the output bits of the counter 12, this number being selected depending on the desired degree of approximation to the exactly triangular form of the area of silicon occupied and consequenly the cost of the generator (the greater the number of bits the greater will be the number of steps and the closer the approximation).

If n = 6 is chosen, as is presently preferred, starting with a 12.8kHz pulse generator there is obtained a triangular wave with a frequency of 100Hz.

The pulse generator 1 may be of any known type. For example it is possible to build a pulse generator as shown in FIG. 3, i.e. with a high frequency triangular wave oscillator 21 followed by a pulse clipper/shaper 22.

**Claims**

1. Low frequency triangular wave generator characterized in that it comprises a high frequency pulse generator (11), an up and down pulse counter (12) with n output bits equipped with a counting direction reversing circuit (13) and a digital/analog converter (16) placed at the output of said counter (12).

2. Triangular wave generator in accordance with claim 1 characterized in that said reversing circuit (13) consists of a flip-flop (13) with output (Q) connected to a reversing input (S/D) of the counter (12) and inputs (R, S) connected to the outputs of respective logic ports (14, 15) of combinations of output bits (U) of the counter (12).

3. Triangular wave generator in accordance with claim 1 characterized in that said pulse generator (11) is composed of a high frequency triangular wave oscillator (21) followed by a pulse clipper/shaper (22).

Fig.1

Fig.2

Fig.3